# EUROPÄISCHE PATENTSCHRIFT

(11) **EP 3 015 877 B1**
(45) Veröffentlichungstag und Bekanntmachung des Hinweises auf die Patenterteilung: **26.10.2016**
(21) Anmeldenummer: 14191269.1
(22) Anmeldetag: 31.10.2014
(51) Int. Cl.: G01R 35/00

(54) **Verfahren zum Kalibrieren einer Strommesseinrichtung**
Method for calibrating a current measuring device
Procédé d'étalonnage d'un dispositif de mesure de courant

(43) Veröffentlichungstag der Anmeldung: 04.05.2016
(73) Patentinhaber: Samsung SDI Co., Ltd., Yongin-si, Gyeonggi-do (KR)
(72) Erfinder: Fritz, Jürgen, 8621 Thörl (AT); Lettner, Markus, 8521 Wettmannstätten (AT); Pretschuh, Markus, 8020 Graz (AT)
(74) Vertreter: Gulde & Partner

(56) Entgegenhaltungen:
- DE-A1-102004 062 655
- DE-A1-102012 224 099
- DE-A1-102012 224 112
- US-A1- 2003 011 355
- US-A1- 2012 218 022
- US-A1- 2014 191 768

## Beschreibung

### Gebiet der Erfindung

Die vorliegende Erfindung betrifft ein Verfahren zum Kalibrieren einer Strommesseinrichtung, wobei die Strommesseinrichtung einen Messwiderstand als Sensor umfasst, und eine solche Strommesseinrichtung.

### Stand der Technik

Strommesseinrichtungen die einen Messwiderstand als Sensor umfassen sind an sich bekannt und bestimmen den zu messenden Strom durch den Spannungsabfall am Messwiderstand. Zur Verbesserung der Genauigkeit derartiger Strommesseinrichtungen ist es bekannt diese Strommesseinrichtungen zu kalibrieren. Dabei wird beispielsweise ein bekannter Referenzstrom an den Messwiderstand angelegt und in Folge die am Messwiderstand anliegende Spannung und ein etwaiger Messfehler der Strommesseinrichtung bestimmt. Die Strommessung durch einen Messwiderstand weist bekanntlich auch eine Temperaturabhängigkeit auf, so dass die Genauigkeit der Messung abhängig von der Umgebungstemperatur und von einer Eigenerwärmung durch den Messwiderstand schwanken kann. Für eine exaktere Kalibrierung ist es daher bekannt eine oder mehrere weitere Messungen bei bekannten Referenzströmen bei unterschiedlichen Temperaturen durchzuführen. Um eine Kalibrierung bei einer unterschiedlichen, zweiten Temperatur durchführen zu können, wird üblicherweise die Strommesseinrichtung in einen Temperatur- bzw. Klimaschrank eingesetzt und somit die ganze Strommesseinrichtung erwärmt oder abgekühlt.

Dieses Vorgehen ist jedoch aufwändig und kostenintensiv. Es nimmt eine relativ lange Zeit in Anspruch bis die erforderlichen Temperaturänderungen erreicht werden. Für einen höheren Durchsatz bei der Kalibrierung müssen daher oft mehrere Temperaturschränke parallel eingesetzt werden. Zudem wird in den eingesetzten Temperaturschränken die Temperatur der gesamten Strommesseinrichtung verändert. Diese arbeiten daher nicht ökonomisch und können die Temperatur von Teilen der betreffenden Schaltung verändern, beispielsweise erhöhen, die nicht erwärmt werden müssen oder auch nicht sollen.

Die DE 102012224099 A1 beschreibt ein Verfahren zum Kalibrieren eines Stromsensors, der eingerichtet ist, einen Strom zu messen und umfasst:das
Anlegen eines Heizstromes an den Stromsensor, das Messen einer Temperatur" die sich aufgrund einer durch den Heizstrom verursachten Verlustleistung am Stromsensor einstellt und das Kalibrieren des Stromsensors bei der gemessenen Temperatur.
Die US 2003/0011355 A1 offenbart eine Reststrom-Erfassungseinrichtung mit einem Stromsensor und einer Temperaturkompensations-Möglichkeit, wobei auf dem Shunt ein A/D-Wandler in einer integrierten Schaltung angeordnet ist.
In den Dokumenten DE 2004062655 A1, DE 102012224112A1, US 2012/0218022 A1 und US 2014/0191768 A1 werden weitere Strommesseinrichtungen mit Kalibrierungsmöglichkeiten beschrieben.

### Zusammenfassung der Erfindung

Es ist eine Aufgabe der Erfindung, die oben angegebenen Nachteile zu vermeiden und insbesondere ein Verfahren zum Kalibrieren einer Strommesseinrichtung anzugeben, dass einfach, schnell und kostengünstig durchgeführt werden kann.

Die Lösung der Aufgabe erfolgt durch ein Verfahren zum Kalibrieren gemäß dem Patentanspruch 1.

Die Strommesseinrichtung umfasst einen Messwiderstand als Sensor, wobei zur Kalibrierung ein erster bekannter Referenzstrom an den Messwiderstand angelegt wird um einen ersten Spannungsabfall am Messwiderstand bei einer ersten Temperatur zu bestimmen, wobei zur Kalibrierung bei einer von der ersten Temperatur verschiedenen zweiten Temperatur der Messwiderstand auf die zweite Temperatur erwärmt wird und ein zweiter bekannter Referenzstrom an den Messwiderstand angelegt wird um einen zweiten Spannungsabfall am Messwiderstand bei der zweiten Temperatur zu bestimmen, wobei der Messwiderstand durch den ersten und/oder zweiten Referenzstrom von der ersten Temperatur auf die zweite Temperatur erwärmt wird.

Dabei istvorgesehen, dass der Referenzstrom selbst gezielt genutzt wird, um die Temperatur am Messwiderstand zu erhöhen.

Die Temperaturänderung wird dabei im Wesentlichen ausschließlich durch den Referenzstrom erreicht und nicht durch eine geänderte Umgebungstemperatur.

Die Temperaturänderung wird insbesondere dadurch erreicht, dass der Messwiderstand und der Referenzstrom geeignet gewählt werden, sodass es zu einer ausreichenden Erwärmung durch die Verlustleistung am Messwiderstand kommt.

Weiterbildungen der Erfindung sind in den abhängigen Ansprüchen, der Beschreibung sowie den beigefügten Zeichnungen angegeben.

Der zweite bekannte Referenzstrom kann bevorzugt unterschiedlich zum ersten bekannten Referenzstrom sein, insbesondere unterschiedliche Pulsdauer und/oder unterschiedliche Amplitude aufweisen. Insbesondere kann wenn die Pulsdauer der beiden Referenzströme unterschiedlich lang ist, die Amplitude beider Referenzströme gleich groß sein.

Bevorzugt wird die Temperatur am Messwiderstand durch einen Temperatursensor ermittelt. Der Temperatursensor ist dann bevorzugt mit dem Messwiderstand optimal thermisch gekoppelt.

Bevorzugt wird zur Kalibrierung der erste bekannte Referenzstrom als kürzerer Strompuls an den Messwiderstand angelegt um den ersten Spannungsabfall am Messwiderstand bei der ersten Temperatur zu bestimmen, da ein kürzerer Strompuls durch die thermische Trägheit zu keiner wesentlichen Erwärmung führt. Der zweite bekannte Referenzstrom wird bevorzugt als längerer Strompuls bzw. mehrere lange Strompulse an den Messwiderstand angelegt um den zweiten Spannungsabfall am Messwiderstand bei der zweiten Temperatur zu bestimmen, um hierdurch die erforderliche Erwärmung zu erzielen. Durch einen entsprechenden Kalibrier-Algorithmus kann die Kalibrierzeit insgesamt optimiert werden.

Die gemessenen Spannungs- und gegebenenfalls Temperaturdaten können in einer Auswerte-Elektronik ausgewertet werden, wobei die Auswerte-Elektronik bevorzugt einen Speicher für im Voraus festgelegte und/oder historische gemessene Kalibrierdaten umfasst.

Eine erfindungsgemäße Strommesseinrichtung umfasst einen Messwiderstand und ist zur Ausführung eines erfindungsgemäßen Verfahrens ausgebildet.

Die Strommesseinrichtung kann bevorzugt einen Messwiderstand zwischen 45 und 130 Mikroohm verwenden, besonders bevorzugt von ca. 100 Mikroohm. Bei einem maximalen Messbereichsendwert von +/- 450 A ergibt sich dabei eine Verlustleistung am Messwiderstand von ca. 20 Watt, die zur Erwärmung des Messwiderstands ausreicht. Der Referenzstrom kann auch größer als der Messbereichsendwert sein. Wesentlich ist der Energieeintrag in den Messwiderstand. Daher verursacht beispielsweise ein Referenzstrom mit doppelter Amplitude, jedoch nur mit einer viertel Pulsdauer den gleichen Energieeintrag wie ein Referenzstrom mit einfacher Amplitude und einer ganzen Pulsdauer.

Die Strommesseinrichtung umfasst vorzugsweise eine Sensor-Elektronik, wobei die Spannung am Messwiderstand durch die Sensor-Elektronik abgegriffen und bevorzugt auch umgeformt wird.

Die Strommesseinrichtung umfasst bevorzugt einen Temperatursensor, der mit dem Messwiderstand thermisch gekoppelt ist.

Vorzugsweise umfasst die Strommesseinrichtung eine Auswerte-Elektronik, wobei die Auswerte-Elektronik einen Speicher für Kalibrierdaten umfasst.

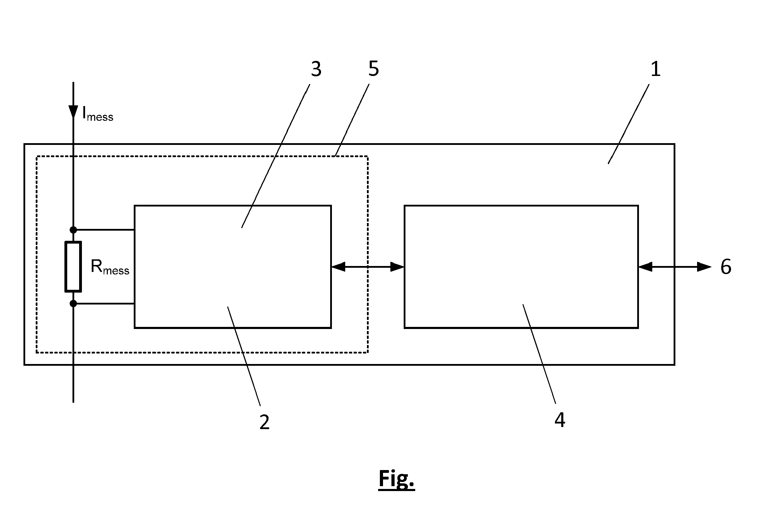

### Kurzbeschreibung der Zeichnung

Die Erfindung wird im Folgenden beispielhaft unter Bezugnahme auf die Zeichnung beschrieben.

Fig. ist ein Blockschaltbild einer erfindungsgemäßen Strommesseinrichtung.

### Detaillierte Beschreibung der Erfindung

In der Fig. ist eine erfindungsgemäße Strommesseinrichtung 1 dargestellt, welche einen Messwiderstand Rₘₑₛₛ umfasst, der an einer Leitung angeordnet ist, durch die ein Referenzstrom Iₘₑₛₛ geleitet werden kann. Der Messwiderstand Rₘₑₛₛ ist mit einer Sensor-Elektronik 3 zum Abgriff der Spannung verbunden, die als Messwert-Umformer ausgebildet ist und auch einen Temperatursensor 2 zur Erfassung der Temperatur am Messwiderstand Rₘₑₛₛ umfasst. Die Sensor-Elektronik 3 mit dem Temperatursensor 2 befindet sich zusammen mit dem Messwiderstand Rₘₑₛₛ in einem thermisch gekoppelten Bereich 5. Mit der Sensor-Elektronik 3 elektrisch verbunden ist eine Auswerte-Elektronik 4, zur Auswertung der ermittelten und gegebenenfalls umgeformten Messwerte, mit einem Speicher für Kalibrierdaten. Die Strommesseinrichtung 1 liefert als Ergebnis der Auswerte-Elektronik 4 einen Messwert 6 der gemessenen Stromstärke.

Ein Verfahren zum Kalibrieren der dargestellten Strommesseinrichtung 1 besteht darin, dass zur Kalibrierung ein bekannter erster Referenzstrom Iₘₑₛₛ an den Messwiderstand Rₘₑₛₛ angelegt wird um einen ersten Spannungsabfall am Messwiderstand Rₘₑₛₛ bei einer ersten Temperatur zu bestimmen, und zur Kalibrierung bei einer von der ersten Temperatur verschiedenen zweiten Temperatur der Messwiderstand Rₘₑₛₛ durch einen zweiten Referenzstrom Iₘₑₛₛ auf die zweite Temperatur erwärmt wird, um einen zweiten Spannungsabfall am Messwiderstand Rₘₑₛₛ bei der zweiten Temperatur zu bestimmen.

Dabei kann der erste bekannte Referenzstrom Iₘₑₛₛ als kürzerer Strompuls an den Messwiderstand Rₘₑₛₛ angelegt werden um den ersten Spannungsabfall am Messwiderstand Rₘₑₛₛ bei der ersten Temperatur zu bestimmen und der zweite bekannte Referenzstrom Iₘₑₛₛ als längerer Strompuls an den Messwiderstand Rₘₑₛₛ angelegt werden um den zweiten Spannungsabfall am Messwiderstand Rₘₑₛₛ bei der zweiten Temperatur zu bestimmen.

Alternativ oder zusätzlich kann der erste bekannte Referenzstrom Iₘₑₛₛ eine andere Amplitude aufweisen als der zweite bekannte Referenzstrom Iₘₑₛₛ.

### Bezugszeichenliste

- 1: Strommesseinrichtung
- 2: Temperatursensor
- 3: Sensor-Elektronik
- 4: Auswerte-Elektronik
- 5: thermisch gekoppelter Bereich
- 6: Messwert

- Rₘₑₛₛ: Messwiderstand
- Iₘₑₛₛ: Referenzstrom

## Patentansprüche

1. Verfahren zum Kalibrieren einer Strommesseinrichtung (1), wobei die Strommesseinrichtung (1) einen Messwiderstand (Rₘₑₛₛ) als Sensor umfasst, wobei zur Kalibrierung ein erster bekannter Referenzstrom (Iₘₑₛₛ) an den Messwiderstand (Rₘₑₛₛ) angelegt wird, um einen ersten Spannungsabfall am Messwiderstand (Rₘₑₛₛ) bei einer ersten Temperatur zu bestimmen, wobei zur Kalibrierung bei einer von der ersten Temperatur verschiedenen zweiten Temperatur der Messwiderstand (Rₘₑₛₛ) auf die zweite Temperatur erwärmt wird und ein zweiter bekannter Referenzstrom (Iₘₑₛₛ) an den Messwiderstand (Rₘₑₛₛ) angelegt wird, um einen zweiten Spannungsabfall am Messwiderstand (Rₘₑₛₛ) bei der zweiten Temperatur zu bestimmen, und wobei der Messwiderstand (Rₘₑₛₛ) durch den ersten und/oder zweiten bekannten Referenzstrom (Iₘₑₛₛ) von der ersten Temperatur auf die zweite Temperatur erwärmt wird und der zweite bekannte Referenzstrom (Iₘₑₛₛ) unterschiedlich zum ersten bekannten Referenzstrom (Iₘₑₛₛ) ist und wobei zur Kalibrierung der erste bekannte Referenzstrom (Iₘₑₛₛ) als kürzerer Strompuls an den Messwiderstand (Rₘₑₛₛ) angelegt wird, um den ersten Spannungsabfall am Messwiderstand (Rₘₑₛₛ) bei der ersten Temperatur zu bestimmen und/oder der zweite bekannte Referenzstrom (Iₘₑₛₛ) als längerer Strompuls an den Messwiderstand (Rₘₑₛₛ) angelegt wird, um den zweiten Spannungsabfall am Messwiderstand (Rₘₑₛₛ) bei der zweiten Temperatur zu bestimmen.

2. Verfahren nach Anspruch 1,
**dadurch gekennzeichnet, dass** die Pulsdauer und/oder die Amplitude der beiden Referenzströme (Iₘₑₛₛ) unterschiedlich ist.

3. Verfahren nach zumindest einem der vorhergehenden Ansprüche,
**dadurch gekennzeichnet, dass** die Temperatur am Messwiderstand (Rₘₑₛₛ) durch einen Temperatursensor (2) ermittelt wird.

4. Verfahren nach zumindest einem der vorhergehenden Ansprüche,
**dadurch gekennzeichnet, dass** die gemessenen Spannungs- und gegebenenfalls Temperaturdaten in einer Auswerte-Elektronik (4) ausgewertet werden, wobei die Auswerte-Elektronik (4) einen Speicher für Kalibrierdaten umfasst.

5. Strommesseinrichtung umfassend einen Messwiderstand,
**dadurch gekennzeichnet, dass** die Strommesseinrichtung (1) zur Ausführung eines Verfahrens nach einem der Ansprüche 1 bis 3 ausgebildet ist.

6. Strommesseinrichtung nach Anspruch 5,
**dadurch gekennzeichnet, dass** der Messwiderstand (Rₘₑₛₛ) 45 bis 130 Mikroohm beträgt, bevorzugt ca. 100 Mikroohm.

7. Strommesseinrichtung nach einem der Ansprüche 5 oder 6,
**dadurch gekennzeichnet, dass** die Strommesseinrichtung (1) eine Sensor-Elektronik (3) umfasst, wobei die Spannung am Messwiderstand (Rₘₑₛₛ) durch die Sensor-Elektronik (3) abgegriffen und bevorzugt umgeformt wird.

8. Strommesseinrichtung nach einem der Ansprüche 5 bis 7,
**dadurch gekennzeichnet, dass** die Strommesseinrichtung (1) einen Temperatursensor (2) umfasst, der mit dem Messwiderstand (Rₘₑₛₛ) thermisch gekoppelt ist.

9. Strommesseinrichtung nach einem der Ansprüche 5 bis 8,
**dadurch gekennzeichnet, dass** die Strommesseinrichtung (1) eine Auswerte-Elektronik (4) umfasst, wobei die Auswerte-Elektronik (4) einen Speicher für Kalibrierdaten umfasst.

## Claims

1. Method for calibrating a current measuring device (1), wherein the current measuring device (1) comprises a measuring resistor (Rₘₑₐₛ) as sensor, wherein for calibration a first known reference current (Iₘₑₐₛ) is applied to the measuring resistor (Rₘₑₐₛ) in order to determine a first voltage drop across the measuring resistor (Rₘₑₐₛ) at a first temperature, wherein for calibration at a second temperature different from the first temperature the measuring resistor (Rₘₑₐₛ) is heated to the second temperature and a second known reference current (Iₘₑₐₛ) is applied to the measuring resistor (Rₘₑₐₛ) in order to determine a second voltage drop across the measuring resistor (Rₘₑₐₛ) at the second temperature, and wherein the measuring resistor (Rₘₑₐₛ) is heated by the first and/or second known reference current (Iₘₑₐₛ) from the first temperature to the second temperature and the second known reference current (Iₘₑₐₛ) is different from the first known reference current (Iₘₑₐₛ) and wherein for calibration the first known reference current (Iₘₑₐₛ) is applied as a shorter current pulse to the measuring resistor (Rₘₑₐₛ) in order to determine the first voltage drop across the measuring resistor (Rₘₑₐₛ) at the first temperature and/or the second known reference current (Iₘₑₐₛ) is applied as a longer current pulse to the measuring resistor (Rₘₑₐₛ) in order to determine the second voltage drop across the measuring resistor (Rₘₑₐₛ) at the second temperature.

2. Method according to claim 1,
**characterised in that** the pulse duration and/or the amplitude of the two reference currents (Iₘₑₐₛ) is different.

3. Method according to at least one of the preceding claims,
**characterised in that** the temperature at the measuring resistor (Rₘₑₐₛ) is detected by a temperature sensor (2).

4. Method according to at least one of the preceding claims,
**characterised in that** the measured voltage data and optionally temperature data are evaluated in evaluation electronics (4), wherein the evaluation electronics (4) comprise a memory for calibration data.

5. Current measuring device comprising a measuring resistor,
**characterised in that** the current measuring device (1) is configured for performing a method according to one of claims 1 to 3.

6. Current measuring device according to claim 5,
**characterised in that** the measuring resistor (Rₘₑₐₛ) has a resistance of 45 to 130 micro-ohms, preferably about 100 micro-ohms.

7. Current measuring device according to one of claims 5 or 6,
**characterised in that** the current measuring device (1) comprises sensor electronics (3), wherein the voltage at the measuring resistor (Rₘₑₐₛ) is tapped and preferably converted by the sensor electronics (3).

8. Current measuring device according to one of claims 5 to 7,
**characterised in that** the current measuring device (1) comprises a temperature sensor (2) which is thermally coupled to the measuring resistor (Rₘₑₐₛ).

9. Current measuring device according to one of claims 5 to 8,
**characterised in that** the current measuring device (1) comprises evaluation electronics (4), wherein the evaluation electronics (4) comprise a memory for calibration data.

## Revendications

1. Procédé d'étalonnage d'un dispositif de mesure de courant (1), le dispositif de mesure de courant (1) comprenant une résistance de mesure (Rₘₑₛₛ) comme capteur, un premier courant de référence (Iₘₑₛₛ) connu étant appliqué sur la résistance de mesure (Rₘₑₛₛ) pour l'étalonnage, afin de déterminer une première chute de tension sur la résistance de mesure (Rₘₑₛₛ) à une première température, la résistance de mesure (Rₘₑₛₛ), pour l'étalonnage, lorsque la deuxième température est différente de la première température, étant chauffée à la deuxième température et un deuxième courant de référence (Iₘₑₛₛ) connu étant appliqué sur la résistance de mesure (Rₘₑₛₛ), afin de déterminer une deuxième chute de tension sur la résistance de mesure (Rₘₑₛₛ) à la deuxième température, et la résistance de mesure (Rₘₑₛₛ) étant chauffée par le premier et/ou le deuxième courant de référence (Iₘₑₛₛ) connu de la première température à la deuxième température et le deuxième courant de référence (Iₘₑₛₛ) étant différent du premier courant de référence (Iₘₑₛₛ) et, pour l'étalonnage, le premier courant de référence (Iₘₑₛₛ) en tant qu'impulsion de courant plus courte étant appliqué sur la résistance de mesure (Rₘₑₛₛ), afin de déterminer la première chute de tension sur la résistance de mesure (Rₘₑₛₛ) à la première température et/ou le deuxième courant de référence (Iₘₑₛₛ) connu étant appliqué en tant qu'impulsion de courant plus longue sur la résistance de mesure (Rₘₑₛₛ), afin de déterminer la deuxième chute de tension sur la résistance de mesure (Rₘₑₛₛ) à la deuxième température.

2. Procédé selon la revendication 1,
**caractérisé en ce que** la durée d'impulsion et/ou l'amplitude des deux courants de référence (Iₘₑₛₛ) sont différentes.

3. Procédé selon au moins l'une des revendications précédentes,
**caractérisé en ce que** la température sur la résistance de mesure (Rₘₑₛₛ) est déterminée par un capteur de température (2).

4. Procédé selon au moins l'une des revendications précédentes,
**caractérisé en ce que** les données mesurées de tension et éventuellement de température sont évaluées dans une électronique d'évaluation (4), l'électronique d'évaluation (4) comprenant une mémoire pour des données d'étalonnage.

5. Dispositif de mesure de courant comprenant une résistance de mesure,
**caractérisé en ce que** le dispositif de mesure de courant (1) est conçu pour la mise en oeuvre d'un procédé selon l'une quelconque des revendications 1 à 3.

6. Dispositif de mesure de courant selon la revendication 5,
**caractérisé en ce que** la résistance de mesure (Rₘₑₛₛ) atteint 45 à 130 micro-ohms, de préférence environ 100 micro-ohms.

7. Dispositif de mesure de courant selon l'une quelconque des revendications 5 ou 6,
**caractérisé en ce que** le dispositif de mesure de courant (1) comprend une électronique de capteur (3), la tension sur la résistance de mesure (Rₘₑₛₛ) étant prélevée par l'électronique de capteur (3) et de préférence convertie.

8. Dispositif de mesure de courant selon l'une quelconque des revendications 5 à 7,
**caractérisé en ce que** le dispositif de mesure de courant (1) comprend un capteur de température (2) qui est accouplé thermiquement à la résistance de mesure (Rₘₑₛₛ).

9. Dispositif de mesure de courant selon l'une quelconque des revendications 5 à 8,
**caractérisé en ce que** le dispositif de mesure de courant (1) comprend une électronique d'évaluation (4), l'électronique d'évaluation (4) comprenant une mémoire pour des données d'étalonnage.
